# EUROPEAN PATENT APPLICATION

(11) **EP 2 267 725 A1**
(43) Date of publication of application: **29.12.2010**
(21) Application number: 09305556.4
(22) Date of filing: 17.06.2009
(51) Int. Cl.: G11C 16/34, G06F 3/06, G06F 12/02, G06F 12/10

(54) **Memory device for managing the recovery of a non volatile memory**

(71) Applicant: Gemalto SA, 92190 Meudon (FR)
(72) Inventor: Daures, Daniel, 92190, MEUDON (FR)

(57) **Abstract**

The invention relates to a memory device (3), comprising:
-a first non volatile memory (1), said first non volatile memory being accessible in reading, writing and/or erasing by blocks;
-a microcontroller (31) including a second non volatile memory (32), said second non volatile memory being accessible in reading, writing and/or erasing by blocks of a size smaller than the first non volatile memory;
-a flash translation layer function (36) managing the read/write access to the blocks of the first non volatile memory (1), recording events and states for block processing of the first non volatile memory in a context metadata log (33) in said second non volatile memory (32), and reading said events and states in order to detect and repair an accidental interruption of a block processing.

## Description

The present invention generally relates to the management of non volatile memories and more particularly to the management of the flash translation layer managing a flash memory device, like a NAND-Flash memory.

Flash memories are commonly found in consumer electronic products. Flash memory is valued in many applications as a storage media due to its fast access speeds, low-power and nonvolatile operation.

Flash memories only allow two states: erased and non-erased. In the erased state, a byte can be either all ones (0xFF) or all zeroes (0x00) depending on the flash device. A bit of data may only be written when it is initially in an erase state. After it is written to, the bit is considered unusable. In order to return the bit to its erase state, a whole memory area called erase zone or erase block must be erased. A block defines the smallest unit that can be erased in the NAND-Flash in a single operation. Flash technology does not allow the toggling of individual bits or bytes from a non-erased state back to an erased state.

Among the various types of flash memories, the NAND-Flash memories are commonly found in embedded systems. A NAND-flash memory is organized into fixed-size pages (for example 512 bytes per page) and a number of pages constitutes a block (for example 32 pages per block). A page defines the smallest unit that can be written in the NAND-Flash in a single operation. The page size thus defines the writing granularity of the NAND-Flash. These access characteristics of the NAND flash memory induce management difficulties.

To have a NAND flash memory work under an existing file system and format (such as FAT16/32, NTFS, EXT2, etc...), the most frequently adopted approach is to maintain an address translation table in map blocks. The address translation table maps logical addresses to physical addresses of the NAND flash memory. As such, the NAND flash memory can be simulated into a continuous memory space and, without altering the existing file system and format, the NAND flash memory can be treated as, for example, a hard disk. This approach is referred to as the NAND flash translation layer (FTL). The FTL is usually software executed by a microcontroller that manages the access to NAND Flash memory. The FTL shields the file system from the erasing details and remaps the data passed to it by writing to unused data areas. When a data block is modified, the file system sees a simple overwriting operation of a given page when new data is in fact written somewhere else on another page. In known FTLs, the NAND Flash memory itself stores both external user data and internal meta-data.

Unexpected power off can occur during the update of the memory contents. To prevent consequences of a power off, such a power off has to be detected. A repair step is carried out once the memory is powered on again.
- if power off occurred during a user data writing step, client layers are in charge of checking the data consistency and carrying out its repair. The FTL guarantees the incompletely written area is ignored during the repair step;
- if power off occurred during the erasing of an obsolete block, the FTL carries out a full erasing step again during the repair step. Thus, the block can be safely reused;
- if power off occurred during a metadata writing step, the FTL has to restore the meta-data into a consistent state.

To proceed with the repair step, the state of the different blocks must be checked. To avoid a systematic check of the state of each page of the blocks, the NAND Flash uses context metadata. A context metadata entry (also called event in the remainder of the document) recites the currently used data log block, the currently used map log block and the possible block under garbage collection. The context metadata log lists the history of block processing and the state of the processing. Based on the context metadata, the FTL can boost its repair process when the NAND flash is rebooted. The time needed for retrieving a consistent state of the NAND-Flash is reduced, which is particularly convenient for devices expecting an immediate turn on, like mobile phones or PDAs.

Usually, a given number of NAND blocks are reserved for logging the successive entries of the context metadata. These blocks remain the same in order to facilitate the context retrieval at the boot stage. Granularity is limited by the size of the pages within these blocks, say between 256 and 4096 bytes. Due to the write access at the page level for a NAND Flash, an atomic update for a context entry (typically 16 to 32 bytes) leads to a writing operation in a very oversized NAND area. If a limited number of blocks are reserved for storing the context metadata log, each page of these blocks is written to very often to update the context metadata entries. These data blocks may then reach their lifetime much more rapidly than the remaining data blocks. The NAND-Flash can then become unserviceable though most of its blocks are still operational. If a great number of blocks are reserved for storing the context log, the life expectancy of these blocks is significantly increased. However, the number of blocks still available for storing data is reduced correspondingly.

To limit the writing operations in the context metadata NAND blocks and avoid the system to be slowed down, it has been proposed to store the context metadata entries in a RAM buffer. The RAM buffer content is saved into context metadata NAND blocks at regular intervals. Due to the page size writing granularity of the NAND-Flash, this saving operation is not carried out at a high frequency. When power off occurs before the RAM buffer is saved into the context log area of the NAND-Flash, several entries are lost and the context cannot be fully retrieved at the next power up.

It has been suggested to store context metadata in the extra spare area of each page to overcome this problem. Extra spare area of a page is a data area of usually 16 to 64 bytes. Using the extra spare area for context metadata could improve the granularity available for its writing. However, this would induce separate writing operations for the page and its spare area. Consequently, the I/O rate of the NAND Flash would be severely degraded. Thus, using such a context metadata storage is not realistic.

Thus, there is a need for a memory device overcoming at least one of these drawbacks. The invention proposes a memory device, comprising:
- a first non volatile memory, said first non volatile memory being accessible in reading, writing and/or erasing by blocks;
- a microcontroller including a second non volatile memory, said second non volatile memory being accessible in reading, writing and/or erasing by blocks of a size smaller than the first non volatile memory;
- a flash translation layer function managing the read/write access to the blocks of the first non volatile memory, recording events and states for block processing of the first non volatile memory in a context metadata log in said second non volatile memory, and reading said events and states in order to detect and repair an accidental interruption of a block processing.

The flash translation layer function may be adapted for recording an update of the state of a block processing event in the context metadata log.

The flash translation layer function may check the state of the last block processing event recorded in the context metadata log when it boots, the flash translation layer function discarding the last processing event recorded if its state indicates that the event was not fully recorded.

The flash translation layer function can be stored in said second non volatile memory.

Said second non volatile memory and said first non volatile memory can be included in the same chip.

Said first non volatile memory can be a NAND-Flash and the second non volatile memory can be a NOR-Flash.

The memory device can comprise a random access memory, and the flash translation function is adapted for generating a consistent context metadata log in said random access memory based on the context metadata log stored in said second non volatile memory when an accidental interruption of a block processing has been detected.

The invention also proposes a method for managing a memory device comprising a first non volatile memory and a microcontroller including a second non volatile memory, said second non volatile memory being accessible in reading, writing and/or erasing by blocks of a smaller size than the first non volatile memory, said method comprising the following steps:
- reading events and states of block processing of the first non volatile memory in a context metadata log stored in said second non volatile memory;
- detecting and repairing an accidental interruption of a block processing based on said reading step.

In an embodiment the method further comprises an updating step and the state of a block processing previously recorded in the context metadata log is updated.

In another embodiment, the repair includes the generation of a consistent context metadata log in a random access memory based on the context metadata log stored in said second non volatile memory.

The advantage of the present invention will become apparent from the following description of several embodiments with reference to the accompanying drawings, in which:
- Figure 1 is a schematic view of an embodiment of the invention;
- Figure 2 is a logical diagram illustrating the context log update for a synchronous event;
- Figure 3 is a logical diagram illustrating the context log update for an asynchronous event;
- Figure 4 is a logical diagram illustrating a recovery process;
- Figure 5 illustrates the structure of an entry in the context log;
- Figure 6 illustrates the structure of an example of context log.

The invention relates to a memory device comprising first and second non volatile memories, both accessible in reading, writing and/or erasing by block. The second non volatile memory is included in a microcontroller. The block size of the second non volatile memory is smaller than that of the first non volatile memory. The invention proposes to maintain a context metadata log describing the history and state of the first non volatile memory in said second non volatile memory. Upon reset, the FTL checks if an accidental power off occurred. When such an accidental power off is detected, the FTL triggers repair actions to run the first non volatile memory in a suitable state.

Thanks to the invention, the first non volatile memory will either present a longer life expectancy or a larger storage area without impairing its recovery ability. Events can be updated in the second non volatile memory with a reduced granularity and thus with an increased frequency, which guarantees a fast and reliable boot after an accidental power off.

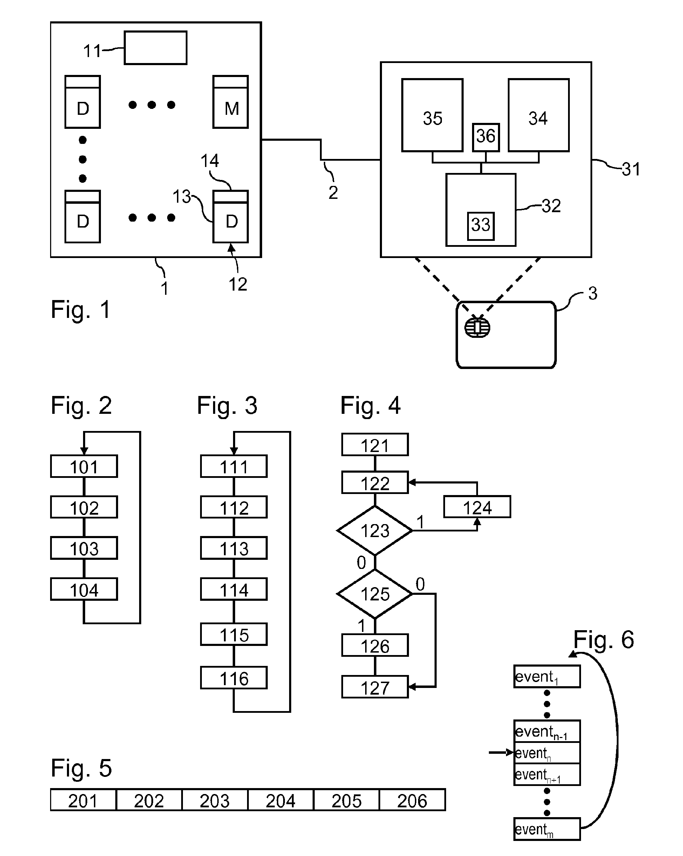

Figure 1 is a schematic view of an embodiment of the invention. A smartcard 3 includes a microcontroller 31. This microcontroller 31 includes a RAM memory 34, a non volatile memory (or NVM) 32, a FTL 36 and a microprocessor 35. The microcontroller 31 is connected to a NAND-Flash memory 1 through a bus 2. The NAND-Flash memory 1 and the microcontroller 31 are embedded in a same chip but are located on different circuits. The size of the NAND Memory 32 can typically be about 256Mo, whereas the size of the non volatile memory can typically be about 394 Ko. Obviously, different memory sizes can also be used without departing from the teaching of the invention. The NAND-Flash 1 and the non volatile memory 32 are preferably of different types.

The Nand-Flash memory 1 includes a controller 11 and an array of data blocks 12. Each block 12 comprises a data storage area 13. Each page of a block is provided with a spare area 14 to store page information. Among the data blocks 12, some data blocks store user data and FTL metadata and are identified by reference D. Some data blocks store map tables and are identified by reference M.

The NAND block types can be as follows:
Spare block: block reserved to replace malfunctioning blocks;
Bad block: either flagged as such by the manufacturer or flagged when a failure is detected at run time;
Current data block: block used for user data logging;
Current map block: block used for map segments logging;
Old data block: block containing live and/or obsolete data pages;
Old map block: block containing live and/or obsolete map segments;
Free block: erased block to be used as new data/map logging block.

The non volatile memory 32 is of a different type than NAND-Flash 1. The non volatile memory 32 can notably be NOR-Flash. Such memories provide a low granularity, a high throughput and a good endurance. A NOR-Flash can notably provide a 1 byte granularity for writing operations.

Memory 32 stores a context metadata log 33. The context metadata log 33 includes a list of events. The list of events can be stored in according to a sequential cycle. Like illustrated at figure 6, the events can be stored in a predefined array of memory spaces identified by event₁ to eventₘ. Each time a new event is generated, this event is written in the next memory space of the metadata context log. Once the end of the memory spaces is reached, the event in the first memory space is erased and overwritten.

The context metadata log 33 provides a macroscopic view of the NAND-Flash 1 processing events. One part of the non volatile memory 32 is used as random access memory for storing the NAND-Flash block processing events and their state. The size of the context metadata log 33 can be for instance of several kilobytes, 8 kilobytes for instance. The usual size of a RAM memory 34 in a smartcard is of several Kbytes. Memory 34 includes RAM buffers for FTL read/write operations, in order to limit the access to memory 32.

The FTL 36 includes a memory management unit and a block reclamation unit. The FTL 36 can be executed by microprocessor 35.

Though non volatile memory 32 has been disclosed previously for storing the context metadata log 33, memory 32 can also store data for different purposes. Memory 32 can notably store an operating system, a file system or applets like Java applets. Memory 32 can also store drivers for the NAND-Flash 1 for allowing an access by the FTL 36. When the context metadata log 33 shares a common storage in memory 32 with other functions, the advantages of the invention can be obtained without requiring additional components. Thus, the invention can thereby be carried out in a very cost effective way.

The logical diagram of figure 2 provides an example of the process carried out for updating the context metadata log 33, in case of a synchronous event.

At step 101, a new block processing is triggered in the NAND-Flash 1. At step 102, this event is written in an event RAM buffer. The state of the event is set at the NONE value in this RAM buffer. At step 103, the event RAM buffer is copied into the context metadata log 33 of the non volatile memory 32. The state of the event is updated to value DONE at step 104 in log 33.

The logical diagram of figure 3 provides an example of the process carried out for updating the context metadata log 33, in case of an asynchronous event.

At step 111, a new block processing is triggered in the NAND-Flash 1. At step 112, this event is written in an event RAM buffer. The state of the event is set at the NONE value in this RAM buffer. At step 113, the event RAM buffer is copied into the context metadata log 33 of the non volatile memory 32. At the beginning of the block processing, the state of the event is updated to value PENDING at step 114 in log 33. The block processing is performed at step 115. Once the block processing is successfully carried out, the event state is updated to value DONE at step 116.

The logical diagram of figure 4 provides an example of the process carried out for recovering the NAND-Flash into RAM 34 after an accidental power off.

At step 121, the NAND-Flash 1 and the microcontroller 31 are booted. At step 122, the FTL 36 locates the last event written in the metadata context log 33. At step 123, the FTL checks if the state of the last recorded event has the value NONE. In such case, the previous event is flagged as the last event. The process then restarts at step 122. If the FTL determines that the state does not have the NONE value, it then checks if the state has the DONE value at step 125. If the state has the DONE value, the FTL knows that the last block processing was successfully carried out and the context is rebuilt based on this last event and the process ends at step 127. Otherwise, the FTL determines that an accidental power off has taken place and the block processing is repaired according to the event type at step 126. The repair process can use either an Undo or a Redo action. The last event can be discarded and not be taken into account. The context is rebuilt based on this repair and the process ends at step 127.

The following event types can notably be recorded in the context metadata log: NEW_DATA (allocation of a new NAND data block), NEW_MAP (allocation of a new NAND map block), ERASE_BLOCK (erasure of a NAND block), STEADY (steady state reached) or FORMAT (format of the NAND blocks array). These events are reflecting context changes of the block processing of NAND-Flash 1.

The following events states can be recorded in the entry (eventₙ) of the context metadata log 33: NONE (code 0xF), PENDING (code 0xE) or DONE (0xC).

In a first example, a block of the NAND-Flash 1 is the current block for storing sequentially the user data. The FTL 36 determines that this current block is full. To store further updates of the user data, the FTL 36 must switch to a new erased block. The FTL 36 checks a list of free erased blocks of the NAND-Flash 1. One of them is selected in the NAND-Flash 1 as the new current data block. An event entry is recorded in a buffer of RAM 34, filled with the FTL context, among which the new data block. The event type is set to NEW_DATA. The state of the event is first set to value NONE, and the RAM event is copied in the non volatile memory event log 33.

If an unexpected power off occurs at that time, it will be detected by the FTL 36 at the next boot due to the stored NONE state. In this case, the FTL 36 discards this event and reads the previous event in the log to retrieve a coherent context for the NAND-Flash block processing. Thus, the selection of the new current block is not taken into account. As the FTL 36 determines that the former current block is full, it carries out the NEW_DATA processing anew to create the necessary new current block.

If the first event logging is successful, another atomic NVM write operation is carried out in the metadata context log to switch the event state to value DONE, thus indicating that the event has been reliably written.

If an unexpected power off occurs next, the FTL 36 reads the DONE state of this last event. The FTL thus knows that the stored context containing the new current data block is reliable. This current block is then used for storing the incoming updated user data.

In a second example, obsolete block erasing is handled. Further to the creation of a new current block in NAND-Flash 1, a garbage collection function is started by the FTL 36 to free another block in compensation. The garbage collection function selects an old block and checks if it still stores data likely to be read (live data). If so, these data are copied into the current block. The checked block is then erased and inserted in the free blocks list.

The live data copy sequence does not need to be protected by a specific event. If an unexpected power off occurs at that time, some page may be copied incompletely in the current data block. This will be detected by the recovery function, either with an ECC check failure or an inconsistency in the page spare area. The recovery will also notice that free blocks are scarce and recall the garbage collection function. The same old block is likely to be selected. Formerly live pages successfully copied will now be found to be obsolete, and only the remaining live pages will be saved.

The following sequence is executed for the erase operation. An event entry is built in a buffer of RAM 34, filled with the FTL context, among which the block being garbaged. The event type is set to ERASE_BLOCK. The state of the event ERASE_BLOCK is firstly set at value NONE and the event stored in RAM is copied into the context metadata log 33.

If an unexpected power off occurs at that time, it will be detected by the FTL 36 at the next boot, due to the NONE state. In this case, the FTL 36 discards this event and reads the previous event in the log to retrieve a coherent context for the NAND-Flash block processing, prior to the old block erasing. Yet the recovery function will realize that free blocks are scarce and recall the garbage collection function. The same old block is likely to be selected. Since all the live data have already been saved, no more copy will occur and only the erase will be redone.

If the first event logging is successful, another atomic NVM write into the event log 33 is performed to switch the event state to value PENDING, indicating that the event has been safely written and that the erase is about to start.

If an unexpected power off occurs next, the FTL 36 reads the PENDING state of the last event, and knows that the stored context containing the currently garbaged block is reliable. Since the erase may be uncompleted, the recovery function will just have to re-post the erase request.

After the event state has been updated to PENDING, an asynchronous erase request for the garbaged block is posted by the FTL 36, and the garbage collection function returns without waiting for the end of the erase operation.

If an unexpected power off occurs next, the FTL 36 finds the same PENDING situation already described and re-posts the erase request.

Eventually, the FTL 36 will be invoked for some NAND-Flash Input/Output requests. Only at this time will it wait until the erase completes. A last atomic write into the context metadata log 33 is then performed to switch the event state to value DONE, indicating that the erase has been completed.

Figure 5 details the structure of an event entry in the context metadata log 33. The size of an entry can be 16 bytes. The processing state is preferably located in the first byte to facilitate its update, corresponding to area 201. The event type is stored in area 202. Area 203 can store the current data block. Area 204 can store the current map block. Area 205 can store the block currently being garbaged (if any). Area 206 can store the free block list.

The FTL software 36 illustrated may be stored in and fetched from the non volatile memory 32. However, the FTL software 36 can also be stored in any suitable memory, for instance a Read Only Memory.

The memory device disclosed in the previous embodiments is a smartcard. The memory device can be of different kinds like a USB key, a large size flash memory card, a multimedia SIM-card or other types of removable devices housing non volatile memories.

## Claims

1. A memory device (3), **characterized in that** it comprises :
- a first non volatile memory (1), said first non volatile memory being accessible in reading, writing and/or erasing by blocks;
- a microcontroller (31) including a second non volatile memory (32), said second non volatile memory being accessible in reading, writing and/or erasing by blocks of a size smaller than the first non volatile memory;
- a flash translation layer function (36) managing the read/write access to the blocks of the first non volatile memory (1), recording events and states for block processing of the first non volatile memory in a context metadata log (33) in said second non volatile memory (32), and reading said events and states in order to detect and repair an accidental interruption of a block processing.

2. A memory device (3) according to claim 1, wherein the flash translation layer function (36) is adapted for recording an update of the state of a block processing event in the context metadata log (33).

3. A memory device (3) according to claim 1, wherein the flash translation layer function (36) checks the state of the last block processing event recorded in the context metadata log (33) when it boots, the flash translation layer function (36) discarding the last processing event recorded if its state indicates that the event was not fully recorded.

4. A memory device (3) according to claim 1, wherein the flash translation layer function (36) is stored in said second non volatile memory (32).

5. A memory device (3) according to claim 1, wherein said second non volatile memory (32) and said first non volatile memory (1) are included in the same chip.

6. A memory device (3) according to claim 1, wherein said first non volatile memory (1) is a NAND-Flash and wherein the second non volatile memory (32) is a NOR-Flash.

7. A memory device (3) according to claim 1, further comprising a random access memory (34), wherein the flash translation function (36) is adapted for generating a consistent context metadata log in said random access memory based on the context metadata log (33) stored in said second non volatile memory when an accidental interruption of a block processing has been detected.

8. Method for managing a memory device (3) comprising a first non volatile memory (1) and a microcontroller (31) including a second non volatile memory (32), said second non volatile memory being accessible in reading, writing and/or erasing by blocks of a smaller size than the first non volatile memory, said method comprising the following steps:
- reading events and states of block processing of the first non volatile memory in a context metadata log (33) stored in said second non volatile memory;
- detecting and repairing an accidental interruption of a block processing based on said reading step.

9. Method according to claim 8, further comprising an updating step wherein the state of a block processing previously recorded in the context metadata log is updated.

10. Method according to claim 9, wherein the repair includes the generation of a consistent context metadata log in a random access memory (34) based on the context metadata log (33) stored in said second non volatile memory (32).
